# EUROPÄISCHE PATENTSCHRIFT

(11) **EP 2 019 579 B1**
(45) Veröffentlichungstag und Bekanntmachung des Hinweises auf die Patenterteilung: **09.06.2010**
(21) Anmeldenummer: 08012359.9
(22) Anmeldetag: 09.07.2008
(51) Int. Cl.: H05K 7/14

(54) **Leistungshalbleitermodul mit verbundenem Substratträger und Herstellungsverfahren hierzu**
High performance semiconductor module with connected substrate carrier and corresponding production method
Module semi-conducteur de puissance doté d'un support de substrat relié et procédé de fabrication correspondant

(30) Priorität: 26.07.2007 DE 102007034849
(43) Veröffentlichungstag der Anmeldung: 28.01.2009
(73) Patentinhaber: SEMIKRON Elektronik GmbH & Co. KG, 90431 Nürnberg (DE)
(72) Erfinder: Kroneder, Christian, 90596 Schwanstetten (DE)

(56) Entgegenhaltungen:
- DE-A1- 10 100 460
- DE-A1- 10 139 287

## Beschreibung

### Beschreibung

Die Erfindung beschreibt ein Leistungshalbleitermodul mit einem Gehäuse, mindestens einem vorzugsweise in einer Aussparung des Gehäuses angeordneten und von dem Gehäuse seitlich umschlossenen Substratträger mit einer hierauf ausgebildeten leistungselektronischen Schaltungsanordnung und von dieser ausgehenden elektrischen Anschlusselementen.

Beispielhaft ist in der DE 101 00 460 A1 ein Leistungshalbleitermodul der genannten Art offenbart, wie es in seiner Grundausprägung seit langem bekannt ist. Derartige Leistungshalbleitermodule gemäß dem Stand der Technik weisen einen Substratträger auf, der den unteren Abschluss des Leistungshalbleitermoduls bildet. Das Isolierstoffgehäuse überragt hierbei diesen Substratträger an seinen Längsseiten geringfügig um ihn zu umschließen. Derartige Substratträger sind häufig ausgebildet als ein flächiger Metallformkörper, vorzugsweise aus Kupfer. Hierdurch ist ein geringer Wärmewiderstand bei wirksamer Wärmespreizung für den Wärmetransport von der leistungselektronischen Schaltungsanordnung zu einem Kühlbauteil gegeben.

Gemäß dem Stand der Technik ist weiterhin bekannt, dass der Substratträger mit dem Gehäuse verklebt ist, um bei einer Befüllung des Gehäuses mit einem zu diesem Zeitpunkt flüssigen Isolierstoff, beispielhaft einem Silikonkautschuk, ein Ausfließen diese Silikonkautschuks zu verhindern. Weiterhin ist das Gehäuse mittels metallischer Nietverbindungen mit dem Substratträger verbunden. Diese Nietverbindungen sind als Hohlkörper mit einer durchgehenden Ausnehmung ausgebildet um ebenso eine Befestigung des Leistungshalbleitermoduls auf einem Kühlbauteil mittels einer Schraubverbindung zu ermöglichen. Gemäß dem Stand der Technik sind diese Nietverbindungen als Messingnieten ausgebildet, da diese auf Grund des Bleianteils des Messings eine gewisse Verformung ermöglichen und somit eine Nietverbindung erst möglich machen.

Auf dem Substratträger selbst ist isoliert von diesem die Schaltungsanordnung des Leistungshalbleitermoduls angeordnet. Hierbei sind verschiedene Schaltungsanordnungen mit Leistungstransistoren, Leistungsdioden und / oder Leistungsthyristoren bekannt. Die Schaltungsanordnung ist mittels isolierender Substrate, beispielhaft DCB- (direct copper bonding) Substrate, von dem Substratträger isoliert.

Weiterhin dem Stand der Technik zuzuordnen sind verschieden ausgestaltete Anschlusselemente für Last- und Hilfsanschlüsse, beispielhaft Steueranschlüsse für gesteuerte Leistungshalbleiterbauelemente. Hierbei sind verschiedene Verbindungstechnologien dieser Anschlusselemente mit dem Substrat oder den Leistungshalbleiterbauelementen der Schaltungsanordnung bekannt. Besonders bevorzugt sind hierbei Lötverbindungen, Druckkontaktverbindungen und / oder Drucksinterverbindungen.

Nachteilig an Leistungshalbleitermodulen gemäß dem Stand der Technik ist, dass der Substratträger sowohl mittels einer Klebe- als auch einer Nietverbindung mit dem Gehäuse verbunden ist was eine sichere Verbindung gewährleistet allerdings auch produktionstechnisch aufwändig ist.

Der Erfindung liegt somit die Aufgabe zugrunde ein Leistungshalbleitermodul mit einem Substratträger vorzustellen, wobei dieser mit Verbindungsmitteln mit dem Gehäuse des Leistungshalbleitermoduls zusammengefügt ist, die einem kostengünstigen und automatisierbaren Herstellungsverfahren zugänglich sind.

Diese Aufgabe wird erfindungsgemäß gelöst, durch einen Gegenstand mit den Merkmalen des Anspruchs 1 sowie durch ein Verfahren gemäß Anspruch 8. Bevorzugte Ausführungsformen sind in den Unteransprüchen beschrieben.

Den Ausgangspunkt der Erfindung bildet ein Leistungshalbleitermodul mit einem Gehäuse, mindestens einem vorzugsweise in einer Aussparung des Gehäuse angeordneten und von dem Gehäuse seitlich, vorzugsweise allseits, umschlossenen Substratträger. Auf diesem Substratträger ist eine leistungselektronische Schaltungsanordnungen ausgebildet von welcher elektrische Anschlusselemente für Last-und Hilfsanschlüsse ausgehen. Der Substratträger bildet somit eine dem Kühlbauteil zugewandte Außenseite oder den Teil einer Außenseite des Leistungshalbleitermoduls.

Erfindungsgemäß weist hierbei der Substratträger mindestens eine vom Inneren des Leistungshalbleitermoduls nach außen reichende durchgehende Ausnehmung auf. Die lichte Weite dieser mindestens einen Ausnehmung des Substratträgers ist auf seiner dem Inneren des Leistungshalbleitermoduls zugewandten inneren Hauptfläche geringer ist als die lichte Weite auf seiner dem Äußeren des Leistungshalbleitermoduls zugewandten äußeren Hauptfläche.

Weiterhin weist das Gehäuse mindestens einen Fortsatz auf, der in die zugeordnete Ausnehmung des Substratträgers hinein reicht und dessen Dicke im Inneren des Substratträgers von Innen nach Außen hin zunimmt. Hierdurch bildet dieser mindestens eine Fortsatz mit dem Substratträger jeweils eine Nietverbindung aus.

Das erfindungsgemäße Verfahren zur Herstellung eines derartigen Leistungshalbleitermoduls weist folgende wesentliche Verfahrensschritte auf:
- Ausbildung eines Gehäuses aus einem Kunststoffmaterial mit mindestens einem zapfenartigen Fortsatz, der in Richtung des Äußeren des Leistungshalbleitermoduls gerichtet ist. Dieser mindestens eine Fortsatz ist hierbei vorzugsweise im Bereich einer Ausnehmung für einen Substratträger angeordnet. Der jeweilige Fortsatz ist hierbei derart ausgebildet, dass er die durch die äußere Hauptfläche des Substratträgers nach dessen Anordnung zu bildende Fläche überragt.
- Anordnung des mindestens einen Substratträgers vorzugsweise in einer zugeordneten Ausnehmung des Gehäuses. Hierbei reicht der mindestens eine Fortsatz des Gehäuses durch die zugeordnete Ausnehmung des Substratträgers hindurch und überragt dessen äußere Hauptfläche.
- Verformung des jeweiligen Endes des mindestens einen Fortsatzes des Gehäuses derart, dass hierdurch dessen Ende sich verbreitert wodurch die jeweilige Nietverbindung ausgebildet wird. Gleichzeitig wird hierdurch der jeweilige Fortsatz innerhalb der durch die äußere Hauptfläche des Substratträgers gebildete Fläche angeordnet. Vorzugsweise erfolgt diese Verformung mittels Einwirkung von Temperatur und / oder Ultraschall.

Es kann hierbei bevorzugt sein durch diese Verformung des mindestens einen Fortsatzes des Gehäuses die zugeordnete Ausnehmung des Substratträgers hinreichend dicht zu verschließen um den Innenraum des Leistungshalbleitermoduls mit einer Vergussmasse zu befüllen, ohne dass diese im Bereich der Ausnehmung austritt.

Es kann weiterhin besonders bevorzugt sein, wenn der Substratträger in seiner Funktionalität durch das Substrat selbst ersetzt wird. Hierbei bildet das Substrat die Begrenzung des Leistungshalbleitermoduls und weist seinerseits die notwendigen Ausnehmungen für die Nietverbindung auf.

Es kann bevorzugt sein, wenn das Gehäuse eine elastische Dichteinrichtung aufweist. Diese ist hierbei umlaufend vorzugsweise um die Aussparung angeordnet und zur inneren Hauptfläche des Substratträgers hin gerichtet.

Durch die beschriebene Ausbildung des erfindungsgemäßen Leistungshalbleitermoduls wird eine einfach herzustellende Verbindung des Gehäuses mit mindestens einem Substratträger erreicht. Diese Nietverbindung ist ausreichend fest um auch die Kräfte aufzunehmen, die auf den Substratträger ausgeübt werden, wenn mindestens eines der Anschlusselemente als Federkontakteinrichtung ausbildet ist.

Besonders bevorzugte Weiterbildungen dieses Halbleiterbauelements sind in der jeweiligen Beschreibung der Ausführungsbeispiele genannt. Die erfinderische Lösung wird zudem an Hand der Ausführungsbeispiele und der Fig. 1 bis 4 weiter erläutert.

Fig. 1 zeigt ein Gehäuse ohne Substratträger eines erfindungsgemäßen Leistungshalbleitermoduls in dreidimensionaler Ansicht.

Fig. 2 zeigt einen Längsschnitt durch ein Gehäuse mit angeordnetem Substratträger eines erfindungsgemäßen Leistungshalbleitermoduls in dreidimensionaler Ansicht.

Fig. 3 zeigt einen Ausschnitt eines erfindungsgemäßen Leistungshalbleitermoduls, wobei Gehäuse und Substratträger zueinander angeordnet sind.

Fig. 4 zeigt einen Ausschnitt eines erfindungsgemäßen Leistungshalbleitermoduls, wobei Gehäuse und Substratträger miteinander verbunden sind.

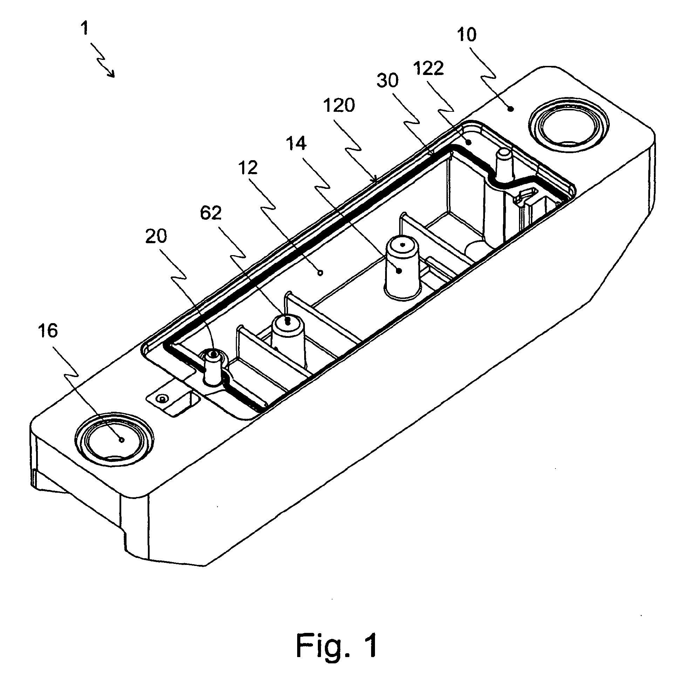

Fig. 1 zeigt ein Gehäuse (10), vorzugsweise aus einem bis über 150°C temperaturstabilen Kunststoff ohne Substratträger eines erfindungsgemäßen Leistungshalbleitermoduls (1) in dreidimensionaler Ansicht. Das Gehäuse (10) weist hierbei an derjenigen Seite die einer nicht dargestellten Kühleinrichtung zugewandt ist, eine Aussparung (12) zur Aufnahme eines Substratträgers, sowie zwei Durchführungen (16) für Schraubverbindungen mit dem Kühlbauteil auf. Diese Aussparung (12) weist hierbei vorteilhafterweise an den beiden Längsseiten des Leistungshalbleitermoduls (1) jeweils einen Steg (120) auf, um den anordenbaren Substratträger an allen Seiten zu umschließen.

Im Inneren des Leistungshalbleitermoduls (1) sind weitere Durchführungen (14) zur Anordnung von Anschlusselementen, hier von als Kontaktfedern (62) ausgebildeten Hilfsanschlusselementen dargestellt. Diese Hilfsanschlusselemente dienen dem externen Anschluss einer Schaltungsanordnung, die auf einem Substratträger angeordnet ist, der in der Aussparung (12) des Gehäuses (10) anordenbar ist.

Im Bereich dieser Aussparung (12), vorteilhafterweise in ihrem Randbereich (122) der Schmalseiten weist das Gehäuse (10) vorzugsweise einstückig mit diesem ausgebildete Fortsätze (20) auf. Diese Fortsätze (20) sind hier zapfenartig ausgebildet und überragen das Gehäuse (10) in Richtung des anzuordnenden Substratträgers.

Weiterhin dargestellt ist ein Dichteinrichtung (30) aus einem elastischen Kunststoff, der vorzugsweise in einem Zwei- Komponenten- Spritzverfahren gemeinsam mit dem Gehäuse (10) hergestellt wurde. Diese Dichteinrichtung (30) bildet eine im Randbereich der Aussparung (12) des Gehäuses (10) umlaufende Dichtlippe, die in bevorzugter Weise die Fortsätze (20) geeignet umschließt, derart dass sich diese Fortsätze (20) außerhalb des Dichtbereichs der Dichtlippe befinden.

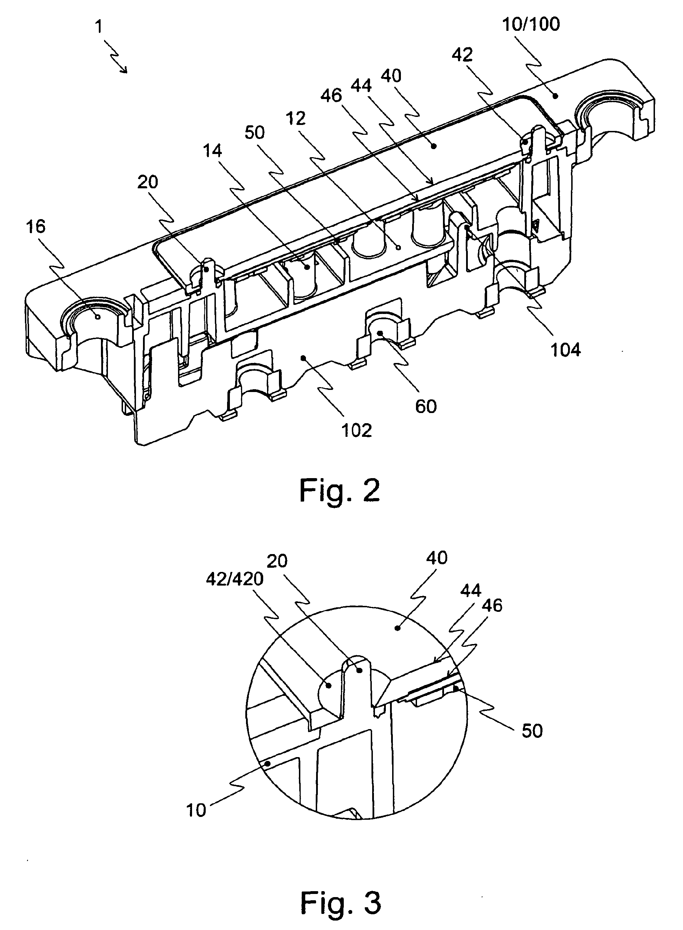

Fig. 2 zeigt eine Längsschnittdarstellung des Gehäuses (10) gemäß Fig. 1 mit angeordnetem Substratträger (40) eines erfindungsgemäßen Leistungshalbleitermoduls (1) in dreidimensionaler Ansicht. Hierbei ist der Substratträger (40) als eine oberflächenveredelte Kupferplatte ausgestaltet. Dieser Substratträger (40) weist fluchtend zu den Fortsätzen (20) des Gehäuses (10) durchgehende Ausnehmungen (42) auf. Diese Ausnehmungen (42) reichen vom Inneren des Leistungshalbleitermodul (1) nach außen, wobei deren lichte Weite auf der dem Inneren des Leistungshalbleitermoduls (1) zugewandten inneren Hauptfläche (44) geringer ist als deren lichte Weite auf der dem Äußeren des Leistungshalbleitermoduls (1) zugewandten äußeren Hauptfläche (46).

Weiterhin dargestellt ist die leistungselektronische Schaltungsanordnung (50), die elektrisch isoliert auf dem Substratträger (40) angeordnet ist. Von dieser Schaltungsanordnung gehen Last- und Hilfsanschlusselement (60) zur externen Verbindung des Leistungshalbleitermoduls (1) aus. Ebenso dargestellt ist die zweiteilige Ausbildung des Gehäuses (10) mit einem Grundgehäuse (100), welches auch die Fortsätze (20) einschließt, und einem Deckel (102), wobei beide mittels einer Schnapp-Rastverbindung (104) miteinander verbunden sind.

Fig. 3 zeigt einen Ausschnitt eines erfindungsgemäßen Leistungshalbleitermoduls (1), wobei Gehäuse (10) und Substratträger (20) zueinander angeordnet sind. Dargestellt ist hier der Substratträger (40) mit der hierauf angeordneten Schaltungsanordnung (50) und das Gehäuse (10) mit einem Fortsatz (20) vor dessen Verformung mittels des erfindungsgemäßen Verfahrens.

Die mit dem Fortsatz (20) des Gehäuses (10) fluchtende Ausnehmung (42) des Substratträgers ist hier kegelstumpfförmig mit der Basis des Kegelstumpfes (420) an der äußeren Hauptfläche (46) des Substratträgers (40) ausgebildet.

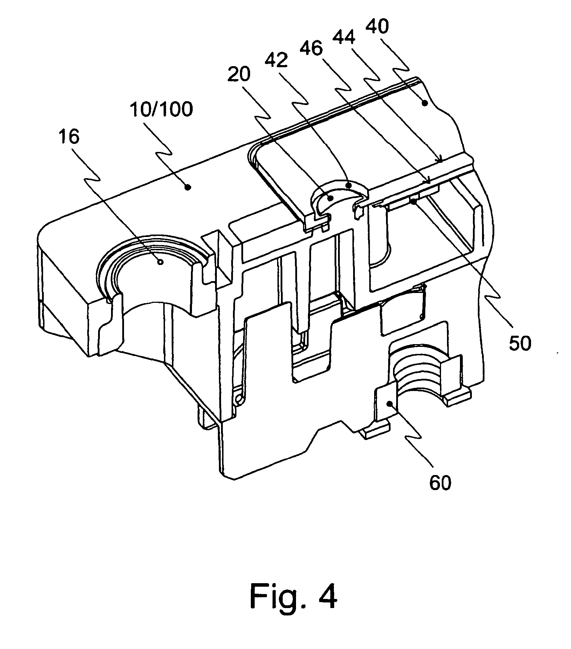

Zur dauerhaltbaren Verbindung des Gehäuses (10) mit dem Substratträger (40) werden die Fortsätze (20) des Gehäuses (10) mittels Temperatur- und / oder Ultraschallbeaufschlagung derart verformt, dass sie gemäß Fig. 4 die äußere Hauptfläche (46) des Substratträgers (40) nicht mehr überragen. Durch die geeignete Ausbildung der Ausnehmungen (42) des Substratträgers (40) können diese das Volumen der verformten Fortsätze (20) vollständig in ihrem Volumen aufnehmen. Durch den nach außen zunehmenden Durchmesser der vorzugsweise rund ausgebildeten Ausnehmungen (42) bildet sich somit eine nietartige Verbindung zwischen dem Gehäuse (10) und dem Substratträger (40) aus.

Es ist hier vorteilhaft, wenn der Substratträger (40) das Gehäuse (10) an seiner äußeren Hauptfläche (46) in Richtung eines Kühlbauteils geringfügig überragt, damit der Substratträger (40) mit dem anordenbaren Kühlbauteil einen vollflächigen Kontakt eingehen kann.

## Patentansprüche

1. Leistungshalbleitermodul (1) mit einem Gehäuse (10), mindestens einem Substratträger (40) mit einer hierauf ausgebildeten Schaltungsanordnung (50) und von dieser ausgehenden elektrischen Anschlusselementen (60, 62),
wobei der Substratträger (40) den Teil einer Aussenseite des Leistungshalbleitermoduls (1) bildet,
wobei der Substratträger (40) mit Verbindungsmittel mit dem Gehäuse (10) des Leistungshalbleitermoduls zusammengefügt ist,
wobei der Substratträger (40) mindestens eine von seiner dem Inneren des Leistungshalbleitermodul (1) zugewandten inneren Hauptfläche (46) zu seiner äußeren Hauptfläche (44) reichende durchgehende Ausnehmung (42) aufweist, deren Ausbildung eine lichte Weite an der inneren Hauptfläche (46) aufweist, die geringer ist als deren lichte Weite auf der äußeren Hauptfläche (44) und
wobei das Gehäuse (10) im Bereich des Substratträgers (40) mindestens einen Fortsatz (20) aufweist, der in diese Ausnehmungen (42) des Substratträgers (40) hinein reicht
und wobei die Verbindung des Gehäuses mit dem Substratträger eine nietartige Verbindung ist, die durch die Verformung des Fortsatzes (20) ausbildet ist, so dass die Ausnehmung (42) das Volumen des verformten Fortsatzes vollständig in ihrem Volumen aufnimmt.

2. Leistungshalbleitermodul nach Anspruch 1,
wobei der Substratträger (40) als eine oberflächenveredelte Kupferplatte ausgestaltet ist auf dessen inneren Hauptfläche (46) eine elektrisch zur Kupferplatte isoliert aufgebaute leistungselektronische Schaltungsanordnung (50) angeordnet ist.

3. Leistungshalbleitermodul nach Anspruch 1,
wobei der Substratträger (40) in einer Aussparung (12) des Gehäuses (10) angeordnet und von dem Gehäuse (10) seitlich umschlossen ist.

4. Leistungshalbleitermodul nach Anspruch 1,
wobei die Nietverbindung des Gehäuses (10) mit dem Substratträgers (40) derart ausgebildet sind, dass die jeweilige Ausnehmung (42) des Substratträgers (40) hinreichend dicht verschlossen ist und der Innenraum des Leistungshalbleitermoduls mit einer Vergussmasse befüllt ist.

5. Leistungshalbleitermodul nach Anspruch 1,
wobei der jeweilige Fortsatz (20) des Gehäuses (10) einstückig mit diesem ausgebildet ist und die Aussparung (12) des Gehäuses (10) umlaufend und zu der inneren Hauptfläche (46) des Substratträgers (40) hin gerichtet eine elastische Dichteinrichtung (30) aufweist.

6. Leistungshalbleitermodul nach Anspruch 1,
wobei zumindest ein Anschlusselement (62) als Federkontakteinrichtung ausbildet ist.

7. Leistungshalbleitermodul nach Anspruch 1,
wobei die jeweilige Ausnehmung (42) des Substratträgers (40) kegelstumpfförmig mit ihrer Basis an der äußeren Hauptfläche (44) ausgebildet ist.

8. Verfahren zur Herstellung eines Leistungshalbleitermoduls (1) nach Anspruch 1, mit den Verfahrensschritten:
• Ausbildung eines Gehäuses (10) aus einem Kunststoff mit mindestens einem zapfenartigen Fortsatz (20), der in Richtung des Äußeren des Leistungshalbleitermoduls (1) gerichtet ist und im Bereich einer zugeordneten Ausnehmung (12) für einen Substratträger (40) angeordnet sind, wobei diese Fortsätze (20) eine durch die äußere Hauptfläche (44) des Substratträgers (40) gebildete Fläche überragen.
• Anordnung des mindestens einen Substratträgers (40) der den Teil einer Aussenseite des Leistungshalbleitermoduls (1) bildet, und der mindestens eine von seiner dem inneren des Leistungs halbleitermodul (1) zugewandten inneren Hauptfläche (46) zu seiner äußeren Hauptfläche (44) reichende durchgehende Ausnehmung (42) aufweist, deren Ausbildung eine lichte Weite an der inneren Hauptfläche (46) aufweist, die geringer ist als deren lichte Weite auf der äußeren Hauptfläche (44) ist, wobei der mindestens eine Fortsatz (20) des Gehäuses (10) durch die zugeordnete Ausnehmung (42) des Substratträgers (40) hindurch reicht und dessen äußere Hauptfläche (44) überragt.
• Verformung des Endes des mindestens eine Fortsatzes (20) des Gehäuses (10) derart, dass hierdurch dieses Ende sich verbreitert, hierbei die Nietverbindung ausbildet, und gleichzeitig innerhalb der durch die äußere Hauptfläche (44) des Substratträgers (40) gebildeten Fläche angeordnet ist.

9. Verfahren nach Anspruch 8,
wobei die Verformung mittels Einwirkung von Temperatur und / oder Ultraschall erfolgt.

10. Verfahren nach Anspruch 8,
wobei anschließend der Innenraum des Leistungshalbleitermoduls (1) zumindest teilweise mit einer elektrisch isolierenden Vergussmasse verfüllt wird.

## Claims

1. A power semiconductor module (1) with a housing (10), at least one substrate carrier (40) with a circuit arrangement (50) designed hereupon, and electrical connector elements (60, 62) emanating from the circuit arrangement, wherein
the substrate carrier (40) forms the part of an outer side of the power semiconductor module (1), wherein
the substrate carrier (40) is joined together with the housing (10) of the power semiconductor module (1) by means of connection, wherein
the substrate carrier (40) has at least one opening (42) extending continuously from its inner main surface (46) facing towards the interior of the power semiconductor module (1) to its outer main surface (44), the design of which opening has a open area on the inner main surface (46) that is smaller than its open area on the outer main surface (44), and wherein
the housing (10) in the region of this substrate carrier (40) has at least one projection (20), which extends into these openings (42) of the substrate carrier (40), and wherein
the connection of the housing with the substrate carrier is a rivet-type joint, which is formed by the deformation of the projection (20) such that the volume of the opening (42) accommodates the volume of the deformed projection completely.

2. The power semiconductor module according to Claim 1, wherein
the substrate carrier (40) is configured as a surface-coated copper plate, on the inner main surface (46) of which is arranged a power electronics circuit arrangement (50) constructed so as to be electrically insulated from the copper plate.

3. The power semiconductor module according to Claim 1, wherein
the substrate carrier (40) is arranged in a recess (12) of the housing (10) and is laterally enclosed by the housing (10).

4. The power semiconductor module according to Claim 1, wherein
the riveted joint of the housing (10) with the substrate carrier (40) is designed such that the particular opening (42) of the substrate carrier (40) is sufficiently tightly sealed and the interior of the power semiconductor module is filled with a potting compound.

5. The power semiconductor module according to Claim 1, wherein
the particular projection (20) of the housing (10) is designed integrally with the latter, and the recess (12) of the housing (10) has a peripheral elastic sealing device (30) aligned with the inner main surface (46) of the substrate carrier (40).

6. The power semiconductor module according to Claim 1, wherein
at least one connector element (62) is designed as a spring contact device.

7. The power semiconductor module according to Claim 1, wherein
the particular opening (42) of the substrate carrier (40) is designed in the form of a truncated cone with its base on the outer main surface (44).

8. The method for the manufacture of a power semiconductor module (1) according to Claim 1, with the steps:
• Design of a housing (10) made of a plastic with at least one projection (20) in the form of a pin, which is aligned in the direction of the exterior of the power semiconductor module (1) and is arranged in the region of an assigned opening (12) for a substrate carrier (40), wherein these projections (20) project through the surface area formed by the outer main surface (44) of the substrate carrier (40).
• Arrangement of the at least one substrate carrier (40) which forms the part of an outer side of the power semiconductor module (1), and which has at least one opening (42) extending continuously from its inner main surface (46) facing towards the interior of the power semiconductor module (1) to its outer main surface (44), the design of which opening has an open area on the inner main surface (46) that is smaller than its open area on the outer main surface (44), wherein the at least one projection (20) of the housing (10) extends through the assigned opening (42) of the substrate carrier (40) and projects beyond its outer main surface (44).
• Deformation of the end of the at least one projection (20) of the housing (10) such that as a result this end widens, hereby forming the riveted joint, and at the same time is arranged within the surface area formed by the outer main surface (44) of the substrate carrier (40).

9. The method according to Claim 8, wherein
the deformation takes place by means of the action of temperature and/or ultrasound.

10. The method according to Claim 8, wherein
the interior space of the power semiconductor module (1) is subsequently at least partially filled with an electrically insulating potting compound.

## Revendications

1. Module à semi-conducteurs de puissance (1) comprenant un boîtier (10), au moins un support de substrat (40) avec un agencement de circuit (50) conçu dessus et des éléments de raccordement (60, 62) électriques partant de ce dispositif, le support de substrat (40) formant la partie d'un côté extérieur du module à semi-conducteurs de puissance (1),
le support de substrat (40) étant assemblé par un moyen de liaison avec le boîtier (10) du module à semi-conducteurs de puissance,
le support de substrat (40) présentant au moins un évidement (42) continu, allant de sa surface principale (46) intérieure, tournée vers l'intérieur du module à semi-conducteurs de puissance (1), vers sa surface principale (44) extérieure, évidement dont la réalisation présente une largeur intérieure sur la surface principale (46) intérieure, qui est plus faible que sa largeur intérieure sur la surface principale (44) extérieure et
le boîtier (10) présentant dans la zone du support de substrat (40) au moins un appendice (20) qui rentre à l'intérieur de ces évidements (42) du support de substrat (40)
et la liaison du boîtier avec le support de substrat étant un assemblage de type rivet, qui est formé par la déformation de l'appendice (20), de sorte que l'évidement (42) reçoit complètement dans son volume le volume de l'appendice déformé.

2. Module à semi-conducteurs de puissance selon la revendication 1,
le support de substrat (40) étant conçu sous forme d'une plaque de cuivre traitée en surface, sur la surface principale (46) intérieure de laquelle est disposé un agencement de circuit (50) à électronique de puissance monté de façon isolée électriquement par rapport à la plaque de cuivre.

3. Module à semi-conducteurs de puissance selon la revendication 1,
le support de substrat (40) étant disposé dans un évidement (12) du boîtier (10) et étant entouré latéralement par le boîtier (10).

4. Module à semi-conducteurs de puissance selon la revendication 1,
l'assemblage rivé du boîtier (10) avec le support de substrat (40) étant conçu de telle sorte que l'évidement (42) respectif du support de substrat (40) est fermé de façon suffisamment étanche et l'espace intérieur du module à semi-conducteurs de puissance est rempli avec une masse de scellement.

5. Module à semi-conducteurs de puissance selon la revendication 1,
l'appendice (20) respectif du boîtier (10) étant formé d'une seule pièce avec celui-ci et présentant un dispositif d'étanchéité (30) élastique en entourant l'évidement (12) du boîtier et en étant dirigé vers la surface principale (46) intérieure du support de substrat (40).

6. Module à semi-conducteurs de puissance selon la revendication 1,
au moins un élément de raccordement (62) étant conçu comme un dispositif de contact à ressort.

7. Module à semi-conducteurs de puissance selon la revendication 1,
l'évidement respectif (42) du support de substrat (40) étant conçu en forme de cône tronqué avec sa base sur la surface principale (44) extérieure.

8. Procédé pour fabriquer un module à semi-conducteurs de puissance (1) selon la revendication 1, présentant les étapes de procédé suivantes :
• Formation d'un boîtier (10) à base d'une matière plastique présentant au moins un appendice (20) en forme de tenon, qui est orienté en direction de l'extérieur du module à semi-conducteurs de puissance (1) et disposé dans la zone d'un évidement (12) associé pour un support de substrat (40), ces appendices (20) dépassant d'une surface formée par la surface principale (44) extérieure du support de substrat (40).
• Agencement du au moins un support de substrat (40), qui forme la partie d'un côté extérieur du module à semi-conducteurs de puissance (1), et qui présente au moins un évidement (42) continu, allant de sa surface principale (46) intérieure, tournée vers l'intérieur du module à semi-conducteurs (1), à sa surface principale (44) extérieure, évidement dont la formation présente une largeur intérieure sur la surface principale (46) intérieure qui est inférieure à sa largeur intérieure sur la surface principale (44) extérieure, le au moins un appendice (20) du boîtier (10) passant à travers l'évidement (42) associé du support de substrat (40) et dépassant de sa surface principale (44) extérieure.
• Déformation de l'extrémité du au moins un appendice (20) du boîtier (10) de telle sorte que cette extrémité s'élargit ainsi, forme dans le cas présent l'assemblage rivé, et est disposée en même temps à l'intérieur de la surface formée par la surface principale (44) extérieure du support de substrat (40).

9. Procédé selon la revendication 8,
la déformation s'effectuant au moyen de l'action de la température et/ou de l'ultrason.

10. Procédé selon la revendication 8,
l'espace intérieur du module à semi-conducteurs de puissance (1) étant rempli ensuite au moins partiellement avec une masse de scellement électriquement isolante.
